# EUROPEAN PATENT APPLICATION

(11) **EP 4 760 780 A1**
(43) Date of publication of application: **17.06.2026**
(21) Application number: 24852092.6
(22) Date of filing: 11.07.2024
(51) Int. Cl.: H01L 21/677, H01L 21/673

(54) **HIGH-PRESSURE SUBSTRATE PROCESSING APPARATUS**

(30) Priority: 10.08.2023 KR 20230104680
(71) Applicant: HPSP Co., Ltd., Hwaseong-si, Gyeonggi-do 18449 (KR)
(72) Inventor: YOON, Hyeseong, Hwaseong-si, Gyeonggi-do 18449 (KR)
(74) Representative: von Bülow & Tamada
(86) International application number: PCT/KR2024/009900
(87) International publication number: WO 2025/033736

(57) **Abstract**

Disclosed is a high-pressure substrate processing apparatus. The high-pressure substrate processing apparatus may include an inner chamber, an outer chamber, and a fastening module. The inner chamber is configured to contain a substrate to be processed and a reaction gas supplied at a first pressure higher than atmospheric pressure. The outer chamber includes an outer housing, an outer door, and an outer sealing member. The outer housing contains the inner chamber. The outer door is configured to be movable between a closed state in which the outer housing is closed and an opened state in which the outer housing is opened. The outer sealing member is formed for sealing between the outer housing and the outer door. The outer chamber is configured to contain a protective gas supplied at a second pressure configured in relation to the first pressure. The fastening module includes a support protrusion and an engaging protrusion. The support protrusion is installed on the outer housing. The engaging protrusion is installed on the outer door so as to be disposed on the support protrusion as the outer door rotates in a state in which the outer sealing member is spaced apart from one of the outer housing and the outer door.

## Description

### [Technical Field]

The present disclosure relates to a processing apparatus used to process a substrate in a high-pressure environment.

### [Background Art]

Generally, during the semiconductor device manufacturing process, various processes are performed on a semiconductor substrate. Examples of the processing include oxidation, nitridation, ion implantation, deposition processes, etc. A hydrogen or deuterium heat treatment process is also used to improve the interface characteristics of the semiconductor device.

The gas used to process the substrate is supplied to the chamber at high-pressure and acts on the semiconductor substrate. To maintain the chamber at high-pressure, the housing of the chamber should be securely closed by a door. When a closed state of the chamber is loosened by high-pressure gas, a gap may be formed between the housing and the door. The gap may become a passage through which the gas within the chamber leaks out.

To securely maintain the closed state between the housing and the door, Korean Patent Laid-Open Publication No. 10-2015-0086831 (July 29, 2015) discloses a rotating fastening ring. The rotating fastening ring is rotatably mounted on the outside of the housing, and as the rotating fastening ring rotates, a first engaging protrusion is aligned with or misaligned from a second engaging protrusion. Due to the size of the rotating fastening ring which surrounds the housing, the rotating fastening ring requires significant power to rotate.

The above-described background art is technical information retained by the inventor to derive the embodiments of the present disclosure or acquired by the inventor while deriving the present disclosure, and thus should not be construed as art that was publicly known prior to the filing date of the present disclosure.

### [Disclosure]

### [Technical Problem]

An object of the present disclosure is to provide a high-pressure substrate processing apparatus capable of reducing power required to fasten the housing and the door while securely maintaining a closed state between a housing and a door even under high-pressure within a chamber.

Another object of the present disclosure is to provide a high-pressure substrate processing apparatus that prevents a sealing member from being damaged when a door is rotated for fastening between the housing and the door.

### [Technical Solution]

To achieve the above problem, according to an aspect of the present disclosure, a high-pressure substrate processing apparatus includes: an inner chamber configured to accommodate a substrate to be processed and a reaction gas supplied at a first pressure higher than atmospheric pressure; an outer chamber including an outer housing accommodating the inner chamber, an outer door configured to be movable between a closed state in which the outer housing is closed and an opened state in which the outer housing is opened, and an outer sealing member configured to seal between the outer housing and the outer door, and configured to accommodate a protective gas supplied at a second pressure set relative to the first pressure; and a fastening module including a support protrusion mounted on the outer housing and an engaging protrusion mounted on the outer door, the engaging protrusion being configured to be disposed on the support protrusion as the outer door rotates in a state in which the outer sealing member is spaced apart from one of the outer housing and the outer door.

The fastening module may further include a sealing adjustment unit configured to adjust the outer sealing member to be in contact with the outer housing and the outer door in a state in which the engaging protrusion is disposed on the support protrusion.

The sealing adjustment unit may include an actuator configured to move the outer sealing member from the other one of the outer housing and the outer door in an approach direction toward the one of the outer housing and the outer door.

The sealing adjustment unit may include: an operating channel formed in the other one of the outer housing and the outer door; and a connecting member configured to connect the outer sealing member and the actuator and disposed within the operating channel so as to be movable along the approach direction.

The operating channel and the connecting member may have a closed-loop shape corresponding to the outer sealing member.

The inner chamber may include an inner housing configured to accommodate the substrate to be processed, an inner door configured to close the inner housing, an inner sealing member configured to seal between the inner housing and the inner door, and a support member that supports the inner door relative to the outer door, and the inner door may be configured to rotate with the outer door by being connected to the outer door via the support member in a state in which the inner sealing member is spaced apart from one of the inner housing and the inner door.

The fastening module may further include a sealing adjustment unit configured to adjust the inner sealing member to be in contact with the inner housing and the inner door in a state in which the engaging protrusion is disposed on the support protrusion.

The sealing adjustment unit may include an actuator configured to move the inner sealing member from the other one of the inner housing and the inner door in an approach direction toward the one of the inner housing and the inner door.

The actuator may be connected to the support member to move the support member and the inner door toward the inner housing.

The high-pressure substrate processing apparatus may further include a door driving module configured to drive the outer door, in which the door driving module may include: a lifting arm configured to be raised and lowered between the opened state and the closed state; and a turntable supporting the outer door and being rotatably mounted on the lifting arm.

The door driving module may further include an actuator configured to rotate one of the outer door and the turntable.

According to another aspect of the present disclosure, a high-pressure substrate processing apparatus includes: a chamber including a housing configured to accommodate a substrate to be processed and a process gas supplied at a pressure higher than atmospheric pressure, a door configured to move between a closed state in which the housing is closed and an opened state in which the housing is opened, and a sealing member configured to seal between the housing and the door; and a fastening module including a support protrusion mounted on the housing and an engaging protrusion mounted on the door and disposed on the support protrusion as the door rotates in the closed state, in which the sealing member is configured to be spaced apart from one of the housing and the door while the door rotates.

The fastening module may further include a sealing adjustment unit configured to adjust the sealing member to be in contact with the housing and the door in a state in which the engaging protrusion is disposed on the support protrusion.

The high-pressure substrate processing apparatus may further include a door driving module configured to drive the door, in which the door driving module may include: a lifting arm configured to be raised and lowered between the opened state and the closed state; and a turntable supporting the door and being rotatably mounted on the lifting arm.

According to still another aspect of the present disclosure, a high-pressure substrate processing apparatus includes: an inner chamber including an inner housing configured to accommodate a substrate to be processed, an inner door configured to close the inner housing, an inner sealing member configured to seal between the inner housing and the inner door, and a support member that supports the inner door, and configured to accommodate a reaction gas supplied at a first pressure higher than atmospheric pressure; an outer chamber including an outer housing accommodating the inner chamber, an outer door that is connected to the support member and configured to be movable along with the inner door between a closed state in which the outer housing is closed and an opened state in which the outer housing is opened, and an outer sealing member configured to seal between the outer housing and the outer door, and configured to accommodate a protective gas supplied at a second pressure set relative to the first pressure; and a fastening module including a support protrusion mounted on the outer housing, and an engaging protrusion mounted on the outer door, the engaging protrusion being configured to be disposed on the support protrusion as the outer door rotates in a state in which the inner sealing member faces the inner housing and the outer sealing member faces the outer housing.

### [Advantageous Effects]

According to the high-pressure substrate processing apparatus of the present disclosure configured as described above, as the housing and the door, which accommodate the substrate and the high-pressure gas, are maintained in the fastened state by the fastening module, and the fastening module is configured to allow the engaging protrusion mounted on the door to rotate with the door and be disposed on the support protrusion mounted on the housing, the fastening between the engaging protrusion and the support protrusion may allow the housing and the door to remain securely closed even under the high-pressure within the chamber. Furthermore, since the engaging protrusion and the support protrusion are fastened as the door rotates, it is possible to reduce the power for fastening between the protrusions.

During the rotation of the door, the sealing member sealing the gap between the housing and the door remains separated from either the housing or the door, thereby preventing damage to the sealing member during door rotation.

### [BRIEF DESCRIPTION OF THE DRAWINGS]

FIG. 1 is a conceptual diagram of a high-pressure substrate processing apparatus according to an embodiment of the present disclosure.
FIG. 2 is an exploded perspective view illustrating an opened state of the high-pressure substrate processing apparatus of FIG. 1.
FIG. 3 is a plan view of an outer door of FIG. 2.
FIG. 4 is a partial cross-sectional view taken along line (IV-IV) of one closed state of the high-pressure substrate processing apparatus of FIG. 2.
FIG. 5 is a partial cross-sectional view of another closed state of the high-pressure substrate processing apparatus of FIG. 2.
FIG. 6 is a conceptual diagram illustrating an appearance in which a door driving module rotates an outer door.
FIG. 7 is a conceptual diagram illustrating an appearance in which the door driving module according to a modified example of the door driving module of FIG. 6 rotates the outer door.

### [Best Mode]

Hereinafter, preferred embodiments of the present disclosure will be described in detail with reference to the accompanying drawings.

The present disclosure is not limited to embodiments set forth herein, but may be modified in various different forms. However, the present embodiment is provided solely to ensure that the disclosure of the present disclosure is complete and to fully inform those skilled in the art of the scope of the invention. It should be understood that the accompanying drawings are provided only in order to allow embodiments disclosed in the present specification to be easily understood, and are not intended to limit the teachings disclosed in the present specification. All the modifications, equivalents, and substitutions may be made without departing from the teachings and the scope of the present disclosure.

It should be understood that the accompanying drawings are provided only in order to allow embodiments disclosed in the present specification to be easily understood, and the teachings disclosed in the present specification are not limited by the accompanying drawings, but includes all the modifications, equivalents, and substitutions included in the teachings and the scope of the present disclosure. In the drawings, components may be exaggerated in size or thickness for ease of understanding, but this should not be construed as limiting the scope of protection of the present disclosure.

Terms used in the present specification are used only in order to describe specific implementation examples or embodiments rather than limiting the present disclosure. Singular expressions are intended to include plural expressions unless the context clearly indicates otherwise. In the specification, terms such as "~comprising," or "~consisting of" are intended to specify the presence of stated features, numbers, steps, operations, components, parts, or combinations thereof described in the specification. That is, it should be understood that terms such as "~including" or "~consisting of" in the specification do not preclude the existence or addition possibility of one or more other features or numbers, steps, operations, components, parts, or combinations thereof.

Terms including ordinal numbers such as "first," "second," etc., may be used to describe various components, but the components are not to be construed as being limited to the terms. The terms are used to distinguish one component from another component.

It is to be understood that when one element is referred to as being "connected to" or "coupled to" another element, it may be connected directly to or coupled directly to another element or be connected to or coupled to another element, having the other element intervening therebetween. On the other hand, it should be understood that when one element is referred to as being "connected directly to" or "coupled directly to" another element, it may be connected to or coupled to another element without the other element interposed therebetween.

When a component is referred to as being "above" or "below" another component, it should be understood that it is not only positioned directly above that other component, but also that other components may be present in between.

Unless indicated otherwise, it is to be understood that all the terms used in the specification including technical and scientific terms have the same meaning as those that are generally understood by those who skilled in the art. Terms generally used and defined by a dictionary should be interpreted as having the same meanings as meanings within a context of the related art and should not be interpreted as having ideal or excessively formal meanings unless being clearly defined otherwise in the present specification.

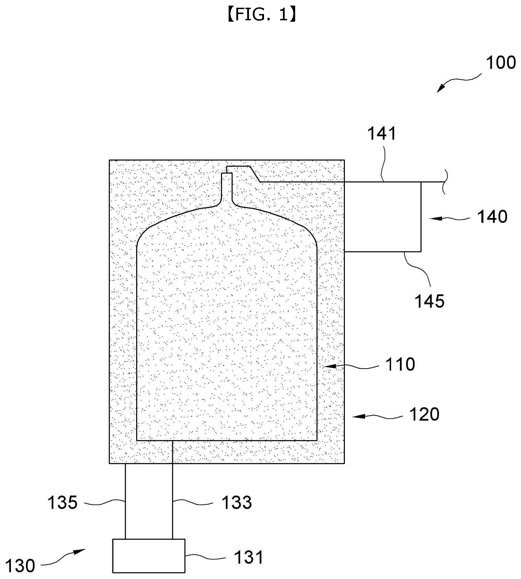

FIG. 1 is a conceptual diagram of a high-pressure substrate processing apparatus according to an embodiment of the present disclosure.

Referring to this drawing, a high-pressure substrate processing apparatus 100 may include an inner chamber 110, an outer chamber 120, a gas supply module 130, and an exhaust module 140.

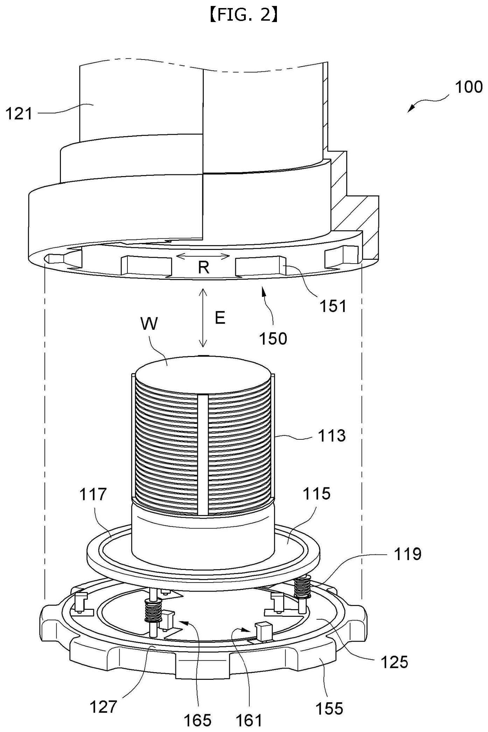

The inner chamber 110 forms a processing space that accommodates an object to be processed, such as a substrate to be processed. The inner chamber 110 may be manufactured from a non-metallic material, such as quartz, to reduce contamination in a high-temperature and high-pressure operating environment. Depending on the operation of a heater (not illustrated) disposed outside the inner chamber 110, the temperature of the inner chamber 110 may reach hundreds to one thousand of °C. The substrate may be, for example, a semiconductor wafer W (see FIG. 2) mounted on a holder or display glass. The holder may be a wafer boat 113 (see FIG. 2) capable of stacking a semiconductor wafer W in multiple layers.

The outer chamber 120 forms an inner space in which the inner chamber 110 is accommodated. The outer chamber 120 is disposed outside the inner chamber 110. Unlike the inner chamber 110, the outer chamber 120 is free from concerns about contamination of the object and may therefore be made of metal material.

The gas supply module 130 is configured to supply gas to the inner chamber 110 and the outer chamber 120. The gas supply module 130 has a gas supply device 131 that serves as a gas source. The gas supply device 131 may selectively supply, to the inner chamber 110, hydrogen gas (H₂), deuterium gas (D₂), fluorine gas (F₂), ammonia gas (NH₃), chlorine gas (Cl₂), or nitrogen gas (N₂) as a reaction gas for heat treatment process. The gas supply device 131 may provide, to the outer chamber 120, a protective gas, such as nitrogen gas or argon gas (Ar) that is the inert gas. The reaction gas and the protective gas may be simply referred to as process gases. The process gases are supplied to the inner chamber 110 or outer chamber 120 via a reaction gas line 133 or a protective gas line 135, respectively. The protective gas supplied to the outer chamber 120 is specifically supplied to a space (protection space) between the outer chamber 120 and the inner chamber 110.

The process gas may be supplied at a pressure (i.e., a high-pressure) higher than atmospheric pressure, for example, at a pressure ranging from several atmospheres to several tens of atmospheres. When the pressure of the reaction gas is a first pressure and the pressure of the protective gas is a second pressure, the first and second pressures may be maintained at a set relationship. For example, the second pressure may be set to be slightly higher than the first pressure. Such a pressure difference provides the advantage of preventing the reaction gas from leaking from the inner chamber 110.

The exhaust module 140 is configured to exhaust the process gas. In order to exhaust the reaction gas from the inner chamber 110, an exhaust pipe 141 is connected to an upper portion of the inner chamber 110. Similarly, to exhaust the protective gas from the outer chamber 120, an exhaust pipe 145 communicating with the outer chamber 120 may be provided. Since these exhaust pipes 141 and 145 are integrated into one, the reaction gas is diluted by the protective gas during the exhaust process, and thus, the concentration of the reaction gas is lowered.

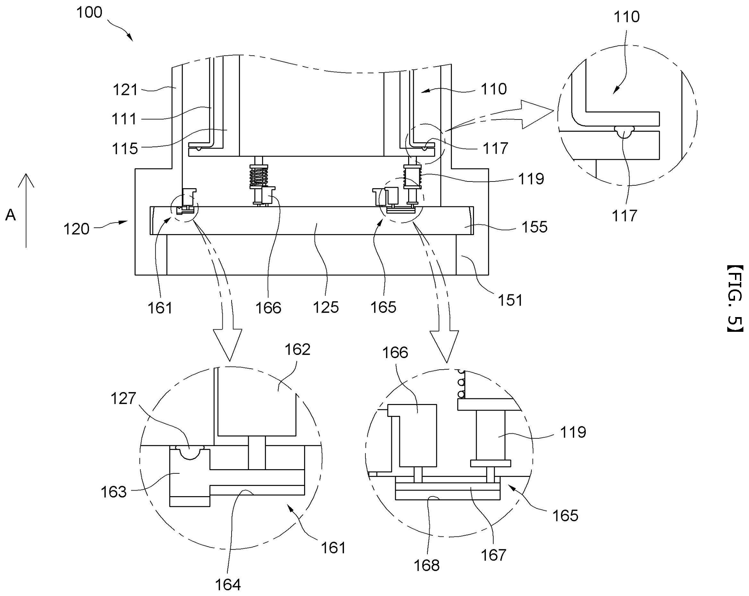

The fastening structure of the outer chamber 120 will be described with reference to FIGS. 2 and 5.

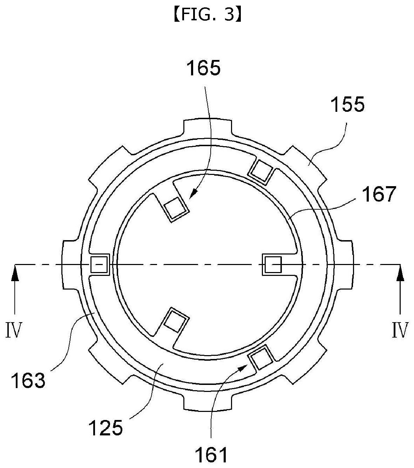

FIG. 2 is an exploded perspective view illustrating an opened state of the high-pressure substrate processing apparatus of FIG. 1, and FIG. 3 is a plan view of the outer door of FIG. 2.

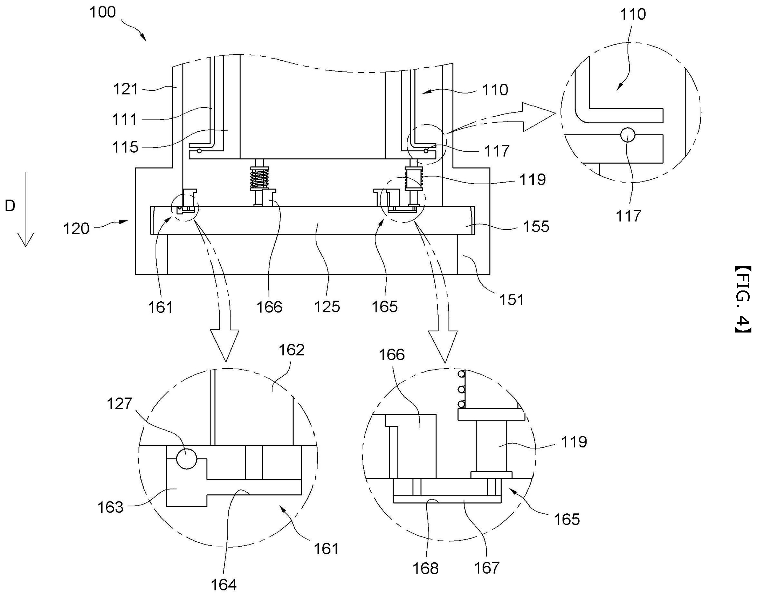

Referring to these drawings, the inner chamber 110 may include an inner housing 111 (see FIG. 4), an inner door 115, an inner sealing member 117, and a support member 119. The inner housing 111 forms the processing space in which the semiconductor wafer W is accommodated, and a lower portion of the inner housing 111 may have an opened form. The inner door 115 has a shape that may close the opened lower portion of the inner housing 111. The inner door 115 may have a trough shape that is generally open downward. The inner sealing member 117 is configured to seal a gap between the inner housing 111 and the inner door 115. The inner sealing member 117 may be, for example, an O-ring mounted on the inner door 115. The inner sealing member 117 is disposed to face the inner housing 111. Unlike this, the inner sealing member 117 may be mounted on the inner housing 111. The support member 119 supports the inner door 115 with respect to the outer door 125. The support member 119 may have a spring support structure that elastically is expanded and contracted along an opening/closing direction E. The opening/closing direction E is a direction in which the inner door 115 moves to transition between the closed state and the opened state (see FIG. 2). When the inner housing 111 is erected, the opening/closing direction E may be a direction corresponding to a lifting or vertical direction. The closed state is a state in which the outer door 125 is positioned at the same level as in FIG. 4 along the opening/closing direction E. In the closed state, the engaging protrusion 155 passes through the space between the support protrusions 151 and approaches the outer housing 121 (unfastened state).

As the inner door 115 is lowered, the processing space is opened (opened state, see FIG. 2). In the opened state, the substrate to be processed is unloaded from the boat 113, and a new substrate to be processed is loaded onto the boat 113. In the raised state of the inner door 115, the processing space may be closed (sealed state, see FIG. 5). In the sealed state, the processing of the semiconductor wafer W, such as heat treatment or deposition, is performed.

The outer chamber 120 also includes the outer housing 121, the outer door 125, and the outer sealing member 127. The outer housing 121 is sized to accommodate the inner chamber 110. The inner housing 111 is mounted on the outer housing 121. The outer door 125 may also move to open/close the outer housing 121. During the transition from the opened state to the closed state, the outer door 125 may move toward the inner door 115 by deformation (compression) of the support member 119. The outer sealing member 127 is for sealing the gap between the outer housing 121 and the outer door 125. The outer sealing member 127 may be, for example, an O-ring mounted on the outer door 125 so as to face the outer housing 121. Unlike this, the outer sealing member 127 may be mounted on the outer housing 121.

The outer door 125 moves along with the inner door 115 by the support member 119 to open/close the outer housing 121. Unlike the above description, the inner door 115 and the outer door 125 are not connected to each other and may be opened/closed independently.

The high-pressure substrate processing apparatus 100 may further include a fastening module 150 for fastening the outer housing 121 and the outer door 125 in the closed state. Since the inner door 115 is supported on the outer door 125 by the support member 119, the fastening module 150 is configured such that the inner door 115 is also in close contact with the inner housing 111. The fastening module 150 maintains the protective gas at the second pressure within the outer chamber 120. The fastening module 150 also exerts a fastening force to maintain the reaction gas at the first pressure within the inner chamber 110.

Specifically, the fastening module 150 may include a support protrusion 151, an engaging protrusion 155, and sealing adjustment units 161 and 165.

The support protrusion 151 is a protrusion mounted on the outer housing 121. As in the present embodiment, the support protrusion 151 may be formed to protrude on an inner peripheral surface of the outer housing 121. The plurality of support protrusions 151 may be disposed along the inner peripheral surface of the outer housing 121. The plurality of support protrusions 151 may be disposed on the same level or plane along the lifting direction E. The support protrusion 151 may be integral with the outer housing 121 or may be manufactured separately and then mounted on the outer housing 121.

The engaging protrusion 155 may be mounted on the outer door 125. Accordingly, the engaging protrusion 155 may have a shape protruding from the outer peripheral surface of the outer door 125. The engaging protrusion 155 may also be integral with the outer door 125 or may be manufactured separately and then coupled to the outer door 125. The engaging protrusion 155 is sized to pass between a pair of adjacent support protrusions 151 when the outer door 125 moves in the opening/closing direction E. The number of engaging protrusions 155 may correspond to the number of support protrusions 151.

The sealing adjustment unit 161 and 165 is configured to separate or contact the sealing member (inner sealing member 117 or outer sealing member 127) with respect to the housing (inner housing 111 or outer housing 121) or the door (inner door 115 or outer door 125). The sealing adjustment unit 161 and 165 may be divided into an (outer) sealing adjustment unit 161 that acts on the outer sealing member 127 and an (inner) sealing adjustment unit 165 that acts on the inner sealing member 117. One sealing adjustment unit 161 may be disposed to surround another sealing adjustment unit 165.

FIG. 4 is a partial cross-sectional view taken along line (IV-IV) of one closed state of the high-pressure substrate processing apparatus of FIG. 2.

Referring to this drawing, as the outer door 125 rotates in the closed state, the engaging protrusion 155 also rotates. The rotated engaging protrusion 155 may be disposed on the support protrusion 151 to be supported by the support protrusion 151 (fastened state). During the transition from the closed state to the fastened state, the level (height) of the outer door 125 along the opening/closing direction E may be maintained unchanged. For this reason, the fastened state may also be understood as one of the closed states. In the fastened state, the outer door 125 is not detached from the outer housing 121 despite the high-pressure of the process gas. The outer door 125 may remain securely fastened to the outer housing 121. During the rotation of the outer door 125, the inner door 115 is also connected to the outer door 125 via the support member 119 and rotates together with the outer door 125.

During the rotation of the outer door 125, the outer sealing member 127 (and inner sealing member 117) faces the outer housing 121 (and inner housing 111). Furthermore, the sealing members 117 and 127 may be maintained in a state separated from the housing 111 and 121 by the operation of the sealing adjustment unit 161 and 165. Specifically, the sealing adjustment unit 161 moves the outer sealing member 127 along a direction D away from the outer housing 121, so the outer sealing member 127 is detached from the outer housing 121. The sealing adjustment unit 165 also moves the inner sealing member 117 along the separation direction D.

The sealing adjustment unit 161 includes an actuator 162 for moving the outer sealing member 127 relative to the outer housing 121. As the actuator 162, for example, a hydraulic/pneumatic cylinder, a linear motor, etc., may be employed. The actuator 162 may be directly connected to the outer sealing member 127 or may be connected via a connecting member 163. In the latter case, the outer sealing member 127 may be mounted on the connecting member 163. The actuator 162 may be mounted to exert a pushing force downward from above the outer sealing member 127. In order to allow the movement along the opening/closing direction E (see FIG. 2) of the connecting member 163, an operating channel 164 may be formed in the outer door 125. The connecting member 163 and the operating channel 164 may have a closed-loop shape, for example, a circular shape, corresponding to the outer sealing member 127 (see FIG. 3).

The sealing adjustment unit 165 for adjusting the inner sealing member 117 is generally the same as the sealing adjustment unit 161 described above. The connecting member 167 is connected to the actuator 166, and an operating channel 168 may also be formed in the outer door 125 for the movement of the connecting member 167. However, the actuator 166 may not be directly connected to the inner sealing member 117 via the connecting member 167, but may be connected to the support member 119. The support member 119 may be connected to the inner door 115, and the inner sealing member 117 may be mounted on the inner door 115. Accordingly, when the actuator 166 is operated, the inner sealing member 117 moves along with the connecting member 167, the support member 119, and the inner door 115.

In the above description, the outer sealing member 127 and the sealing adjustment unit 161 are exemplified as being mounted on the outer door 125, but the outer sealing member 127 and the sealing adjustment unit 161 may also be mounted on the outer housing 121. In addition, when the sealing member expands/contracts due to the pressure fluctuations caused by the supply/exhaust of the process gas, the sealing adjustment units 161 and 165 may not be necessary. When the sealing member contracts in a state in which the process gas is exhausted from the chamber 110 and 120, the sealing member may not be damaged when the outer door 125 rotates by being separated from the housing 111 and 121. In addition, when the sealing member expands due to the pressure of the process gas supplied to the chamber 110 and 120 in the fastened state, the sealing member will seal the gap between the housings 111 and 121 and the doors 115 and 125, thereby achieving the sealing state.

FIG. 5 is a partial cross-sectional view of another closed state of the high-pressure substrate processing apparatus of FIG. 2.

Referring further to this drawing, in the above-described fastened state, the outer sealing member 127 may move along the approach direction A by the operation of the sealing adjustment unit 161. The approach direction A is a direction in which the outer sealing member 127 approaches the outer housing 121, and may follow a direction in which the outer door 125 moves toward the outer housing 121. A moving end of the actuator 162 exerts force along the approach direction A. By the operation of the sealing adjustment unit 161, the outer sealing member 127 comes into contact with the outer housing 121, thereby sealing the gap between the outer housing 121 and the outer door 125 (sealed state).

Similarly, depending on the operation of the sealing adjustment unit 165, the inner sealing member 117 may seal the gap between the inner housing 111 and the inner door 115.

By reaching the fastened and sealed states, the protective gas within the outer chamber 120 may be maintained at the second pressure. The reaction gas within the inner chamber 110 may be maintained at the first pressure. Furthermore, during the fastened and sealed states, damage to the sealing member due to friction with a counterpart (such as the outer housing 121) may be fundamentally prevented. By preventing damage to the sealing member, the possibility of particle generation from the sealing member and the possibility of leakage of the reaction gas and the protective gas may be significantly reduced.

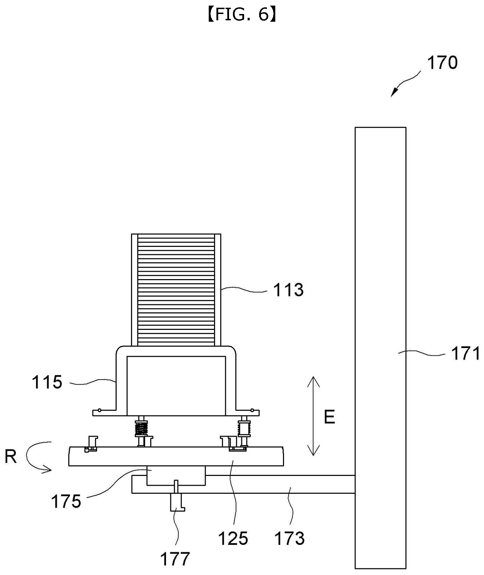

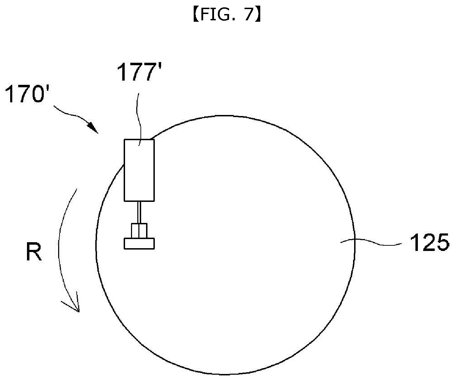

Next, the method for rotating the outer door 125 will be described with reference to FIGS. 6 and 7.

FIG. 6 is a conceptual diagram illustrating the door driving module rotating the outer door.

Referring to this drawing, the door driving module 170 may be employed to drive the outer door 125.

The door driving module 170 may have a frame 171 disposed to extend along the opening/closing direction E. The lifting arm 173 disposed along a direction generally perpendicular to the opening/closing direction E may be connected to the frame 171. The lifting arm 173 moves along the opening/closing direction E and moves the outer door 125 along the opening/closing direction E.

The turntable 175 may be mounted on the lifting arm 173. The turntable 175 is a part that supports the outer door 125. The turntable 175 may be mounted to be rotatable relative to the lifting arm 173. To rotate the turntable 175, an actuator 177 may be connected to the turntable 175. The actuator 177 may be mounted on the lifting arm 173 and output a rotational force. For example, the actuator 177 may be a motor having a rotational shaft connected to the turntable 175.

With this configuration, the outer door 125 may move from the opened state to the closed state depending on the operation of the lifting arm 173. When the turntable 175 rotates due to the operation of the actuator 177, the outer door 125 may also rotate and reach the fastened state.

FIG. 7 is a conceptual diagram illustrating an appearance in which the door driving module according to a modified example of the door driving module of FIG. 6 rotates the outer door.

Referring further to this drawing, a door driving module 170' may include an actuator 177' that directly rotates the outer door 125.

The actuator 177' outputs a linear driving force and may be, for example, a hydraulic/pneumatic cylinder or a linear motor. An output terminal of the actuator 177' may be connected to a bottom surface of the outer door 125. The other end portion of the actuator 177' may be mounted on the outer housing 121. In response to the lifting of the lifting arm 173, the actuator 177' may be mounted to be able to move up and down relative to the outer housing 121.

With this configuration, the outer door 125 rotates along with the turntable 175 as the actuator 177' rotates the outer door 125.

Although this specification exemplifies the high-pressure substrate processing apparatus 100 with a dual chamber, the present disclosure is not limited thereto. A processing apparatus with a single chamber is also within the scope of the present disclosure. The single chamber includes one housing and one door. The wafer substrate is disposed within the chamber, and the gas for processing the wafer substrate is supplied. The fastening module 150 (and door driving module 170 and 170') are also applicable to this single chamber. The fastening module 150 ensures that the door is securely fastened to the housing, even under gas pressure. Furthermore, the sealing member for sealing between the door and the housing is adjusted by the sealing adjustment unit, so the sealing member is not damaged when rotated.

The configuration of the fastening module 150, etc., may also be applied to a semi-dual chamber, which is an intermediate configuration between the dual chamber and the single chamber. The semi-dual chamber may have two housings (the inner housing and the outer housing) and one door. The two housings may correspond to the inner housing 111 and the outer housing 121 of the above-described embodiment. The two housings may be connected by their own shapes or by intervening with a separate member to form a closed space (corresponding to the protection space). As in the embodiment described above, the substrate may be disposed in the processing space of the inner housing, the reaction gas may be injected, and the protective gas may be injected into the closed space. Unlike the above-described embodiments, the door is not protected by the protective gas.

The door may correspond to the outer door 125 of the above-described embodiments. The door may open/close the inner housing (and the outer housing). The fastening module 150 (and the door driving module 170 and170') etc., as in the above-described embodiments is applied to the operation between the outer housing and the door.

While the present specification exemplifies a batch-type processing apparatus, the present disclosure is not limited thereto. The present disclosure may also be applied to a single wafer type processing apparatus.

### [Industrial Applicability]

The present disclosure has industrial applicability in the field of manufacturing the high-pressure substrate processing apparatus.

## Claims

1. A high-pressure substrate processing apparatus, comprising:
an inner chamber configured to accommodate a substrate to be processed and a reaction gas supplied at a first pressure higher than atmospheric pressure;
an outer chamber including an outer housing accommodating the inner chamber, an outer door configured to be movable between a closed state in which the outer housing is closed and an opened state in which the outer housing is opened, and an outer sealing member configured to seal between the outer housing and the outer door, and configured to accommodate a protective gas supplied at a second pressure set relative to the first pressure; and
a fastening module including a support protrusion mounted on the outer housing and an engaging protrusion mounted on the outer door, the engaging protrusion being configured to be disposed on the support protrusion by rotation of the outer door in a state in which the outer sealing member is spaced apart from one of the outer housing and the outer door.

2. The high-pressure substrate processing apparatus of claim 1, wherein the fastening module further includes a sealing adjustment unit configured to adjust the outer sealing member to be in contact with the outer housing and the outer door in a state in which the engaging protrusion is disposed on the support protrusion.

3. The high-pressure substrate processing apparatus of claim 2, wherein the sealing adjustment unit includes an actuator configured to move the outer sealing member from the other one of the outer housing and the outer door in an approach direction toward the one of the outer housing and the outer door.

4. The high-pressure substrate processing apparatus of claim 3, wherein the sealing adjustment unit includes:
an operating channel formed in the other one of the outer housing and the outer door; and
a connecting member configured to connect the outer sealing member and the actuator and disposed within the operating channel so as to be movable along the approach direction.

5. The high-pressure substrate processing apparatus of claim 4, wherein the operating channel and the connecting member have a closed-loop shape corresponding to the outer sealing member.

6. The high-pressure substrate processing apparatus of claim 1, wherein the inner chamber includes an inner housing configured to accommodate the substrate to be processed, an inner door configured to close the inner housing, an inner sealing member configured to seal between the inner housing and the inner door, and a support member that supports the inner door relative to the outer door, and
the inner door is configured to rotate with the outer door by being connected to the outer door via the support member in a state in which the inner sealing member is spaced apart from one of the inner housing and the inner door.

7. The high-pressure substrate processing apparatus of claim 6, wherein the fastening module further includes a sealing adjustment unit configured to adjust the inner sealing member to be in contact with the inner housing and the inner door in a state in which the engaging protrusion is disposed on the support protrusion.

8. The high-pressure substrate processing apparatus of claim 7, wherein the sealing adjustment unit includes an actuator configured to move the inner sealing member from the other one of the inner housing and the inner door in an approach direction toward the one of the inner housing and the inner door.

9. The high-pressure substrate processing apparatus of claim 8, wherein the actuator is connected to the support member to move the support member and the inner door toward the inner housing.

10. The high-pressure substrate processing apparatus of claim 1, further comprising:
a door driving module configured to drive the outer door,
wherein the door driving module includes:
a lifting arm configured to be raised and lowered between the opened state and the closed state; and
a turntable supporting the outer door and being rotatably mounted on the lifting arm.

11. The high-pressure substrate processing apparatus of claim 10, wherein the door driving module further includes an actuator configured to rotate one of the outer door and the turntable.

12. A high-pressure substrate processing apparatus, comprising:
a chamber including a housing configured to accommodate a substrate to be processed and a process gas supplied at a pressure higher than atmospheric pressure, a door configured to move between a closed state in which the housing is closed and an opened state in which the housing is opened, and a sealing member configured to seal between the housing and the door; and
a fastening module including a support protrusion mounted on the housing and an engaging protrusion mounted on the door and disposed on the support protrusion as the door rotates in the closed state,
wherein the sealing member is configured to be spaced apart from one of the housing and the door in a state in which the door rotates.

13. The high-pressure substrate processing apparatus of claim 12, wherein the fastening module further includes a sealing adjustment unit configured to adjust the sealing member to be in contact with the housing and the door in a state in which the engaging protrusion is disposed on the support protrusion.

14. The high-pressure substrate processing apparatus of claim 13, further comprising:
a door driving module configured to drive the door,
wherein the door driving module includes:
a lifting arm configured to be raised and lowered between the opened state and the closed state; and
a turntable supporting the door and being rotatably mounted on the lifting arm.

15. A high-pressure substrate processing apparatus, comprising:
an inner chamber including an inner housing configured to accommodate a substrate to be processed, an inner door configured to close the inner housing, an inner sealing member configured to seal between the inner housing and the inner door, and a support member that supports the inner door, and configured to accommodate a reaction gas supplied at a first pressure higher than atmospheric pressure;
an outer chamber including an outer housing accommodating the inner chamber, an outer door that is connected to the support member and configured to be movable along with the inner door between a closed state in which the outer housing is closed and an opened state in which the outer housing is opened, and an outer sealing member configured to seal between the outer housing and the outer door, and configured to accommodate a protective gas supplied at a second pressure set relative to the first pressure; and
a fastening module including a support protrusion mounted on the outer housing, and an engaging protrusion mounted on the outer door, the engaging protrusion being configured to be disposed on the support protrusion as the outer door rotates in a state in which the inner sealing member faces the inner housing and the outer sealing member faces the outer housing.
